Europäisches Patentamt

European Patent Office

Office européen des brevets

(11) Veröffentlichungsnummer: **0 489 312 A1**

# EUROPÄISCHE PATENTANMELDUNG

(21) Anmeldenummer: **91119851.3**

(22) Anmeldetag: **21.11.91**

(51) Int. Cl.⁵: **G01R 33/36**

(30) Priorität: **04.12.90 DE 4038648**

(43) Veröffentlichungstag der Anmeldung:
**10.06.92 Patentblatt 92/24**

(84) Benannte Vertragsstaaten:
**DE GB**

(71) Anmelder: **SIEMENS AKTIENGESELLSCHAFT**
**Wittelsbacherplatz 2**
**W-8000 München 2(DE)**

(72) Erfinder: **Dürr, Wilhelm, Dr.**
**Damaschkestrasse 99**
**W-8520 Erlangen(DE)**

(54) **Anordnung zum Herstellen von Schnittbildern durch magnetische Kernresonanz.**

(57) Die Anordnung enthält eine Hochfrequenzanten-ne, deren Induktivität mit wenigstens einem Reso-nanzkondensator einen Resonanzkreis bildet. Erfin-dungsgemäß sind Mittel zur Begrenzung der Span-nung $U_c$ am Resonanzkondensator (11) vorgesehen. Eine Überdimensionierung des Resonanzkreises (10) ist somit nicht erforderlich.

FIG 1

EP 0 489 312 A1

Die Erfindung bezieht sich auf eine Anordnung zum Herstellen von Schnittbildern eines Untersuchungsobjektes durch magnetische Kernresonanz mit einem magnetischen Grundfeld sowie Gradientenfeldern und einer Hochfrequenzantenne, deren Induktivität mit wenigstens einem Resonanzkondensator einen Resonanzkreis bildet.

Es sind Geräte zum Erzeugen von Schnittbildern eines Untersuchungsobjekts, vorzugsweise eines menschlichen Körpers, mit magnetischer Kernresonanz bekannt. Diese sogenannten Kernspintomographen enthalten einen Grundfeldmagneten, der die Kernspins im menschlichen Körper ausrichtet und ferner Gradientenspulen, die ein räumlich unterschiedliches Magnetfeld erzeugen und schließlich Hochfrequenzspulen zur Anregung der Kernspins und zum Empfang der von den angeregten Kernspins emittierten Signale. Beim Einsatz einer derartigen hochfrequenten Anregungs- und Meßspule wird die Induktivität der Spule zusammen mit einer Kapazität als LC-Resonanzkreis geschaltet, wobei dann die Kondensatoranordnung der gewünschten Frequenz entsprechend abgestimmt wird. Zu diesem Zweck ist im allgemeinen eine veränderbare Parallelkapazität sowie eine in der Zuleitung angeordnete Serienkapazität zur Ankopplung des Resonators an einen Hochfrequenzgenerator vorgesehen, der vorzugsweise ein Oszillator mit einem nachgeschalteten Sendeverstärker sein kann. Als veränderbare Kapazitäten werden im allgemeinen Drehkondensatoren verwendet, deren Kapazität durch Elektromotoren gesteuert werden kann.

Der Resonator wird je nach der Größe des Untersuchungsobjekts, beispielsweise eines Patienten, unterschiedlich stark belastet, d.h. bedämpft. Bei der Anpassung des Resonators an den Hochfrequenzgenerator, dessen Wellenwiderstand beispielsweise 50 Ohm betragen kann, erhält man somit Anpaßfrequenzen, die vom Belastungsgrad des Resonators abhängig sind. Die Eigenfrequenz des Resonators muß deshalb so verstimmt werden, daß die durch die unterschiedliche Belastung des Resonators bedingte Abwicklung der Resonanzfrequenz vom Sollwert wieder kompensiert wird. Zu diesem Zweck wird nach der Einführung eines Patienten in den Kernspintomographen eine Abstimmung des Resonators dadurch vorgenommen, daß die Serienkapazität zur Lastanpassung und die Parallelkapazität zur Frequenzkorrektur nacheinander solange verstellt werden, bis die erforderliche Abstimmung erreicht ist.

Die Leerlaufgüte des Resonators beträgt im allgemeinen etwa 500 bis 1000. Bei Belastung durch einen Patienten sinkt diese Güte normalerweise auf Werte unter 100. Für diesen Fall muß auch die Leistung des Hochfrequenzgenerators ausgelegt sein. Alle kleineren Lastfälle erfordern kleinere Hochfrequenzleistungen, d.h. wird die volle Verstärkerleistung im Leerlauf oder bei schwacher Last, beispielsweise durch ein Kind als Patienten, auf die Antenne gegeben, so können unzulässige Spannungs- oder Stromspitzen entstehen. Diese könnten zwar durch entsprechende Auslegung der Software ausgeschlossen werden; aus Sicherheitsgründen werden aber solche Antennen für diese maximale Belastung ausgelegt, die etwa um den Faktor 3 höher liegt als erforderlich.

Der Erfindung liegt nun die Aufgabe zugrunde, diese bekannten Kernspintomographen zu vereinfachen und zu verbessern, insbesondere soll eine Überdimensionierung des Resonators vermieden und zugleich sollen unzulässige Spitzenamplituden des Hochfrequenzfeldes im Falle einer Fehlbedienung ausgeschlossen werden.

Die Erfindung beruht auf der Erkenntnis, daß unzulässige Spitzenamplituden vermieden werden können, wenn nach dem Überschreiten eines Spannungsgrenzwertes am Resonator durch Einsatz elektronischer Mittel ein weiterer Anstieg innerhalb sehr kurzer Zeit herbeigeführt wird, die 100 ns nicht wesentlich überschreitet.

Die genannte Aufgabe wird nun erfindungsgemäß gelöst durch das kennzeichnende Merkmal des Anspruchs 1. In einer besonders einfachen Ausführungsform der Anordnung gemäß der Erfindung können dem Resonanzkondensator elektronische Begrenzungselemente, beispielsweise Zenerdioden oder Varistoren oder auch Überspannungsableiter, parallelgeschaltet werden, die beim Überschreiten eines vorbestimmten Grenzwertes der Spannung im Resonanzkreis wirksam werden und nach einer geringen, ungefährlichen Spannungsüberhöhung einen weiteren Spannungsanstieg verhindern.

In einer besonders vorteilhaften Anordnung können Mittel vorgesehen sein zur Verstimmung des Resonanzkreises. In dieser Ausführungsform ist dem Resonanzkondensator eine Einrichtung zur Spannungsmessung zugeordnet, die eine der Spannung am Resonanzkondensator proportionale Spannung einem Spannungskomparator liefert. Der Spannungskomparator schaltet eine PIN-Diode durch, sobald die gemessene Spannung einen vorbestimmten Grenzwert überschreitet. Mit Hilfe der PIN-Diode wird der Resonanzkreis verstimmt und dadurch ein unzulässiger Spannungsanstieg verhindert. Ferner kann mit Hilfe der PIN-Diode auch der Reflexionsfaktor der Antenne erhöht und dadurch die Leistungszufuhr entsprechend begrenzt werden. Außerdem kann mit dem Ausgangssignal des Spannungskomparators auch die Leistungszufuhr zum Resonator unterbrochen werden, sobald ein vorzugsweise einstellbarer Spannungsgrenzwert überschritten wird. Weitere besonders vorteilhafte Ausgestaltungen ergeben sich aus den Unteransprüchen.

Zur weiteren Erläuterung der Erfindung wird auf die Zeichnung Bezug genommen, in deren Figur 1 ein Ausführungsbeispiel einer Anordnung zum Herstellen von Schnittbildern gemäß der Erfindung schematisch veranschaulicht ist. In Figur 2 ist ein Diagramm zur Erläuterung der Wirkungsweise dargestellt. Figur 3 zeigt eine Anordnung mit einer Spannungsbegrenzung durch Verstimmung des Resonators und in Figur 4 ist eine Spannungsbegrenzung durch Begrenzung der Leistungszufuhr veranschaulicht. In Figur 5 ist eine einfache Möglichkeit zur Spannungsbegrenzung durch Unterbrechung der Leistungszufuhr zum Resonanzkreis angedeutet.

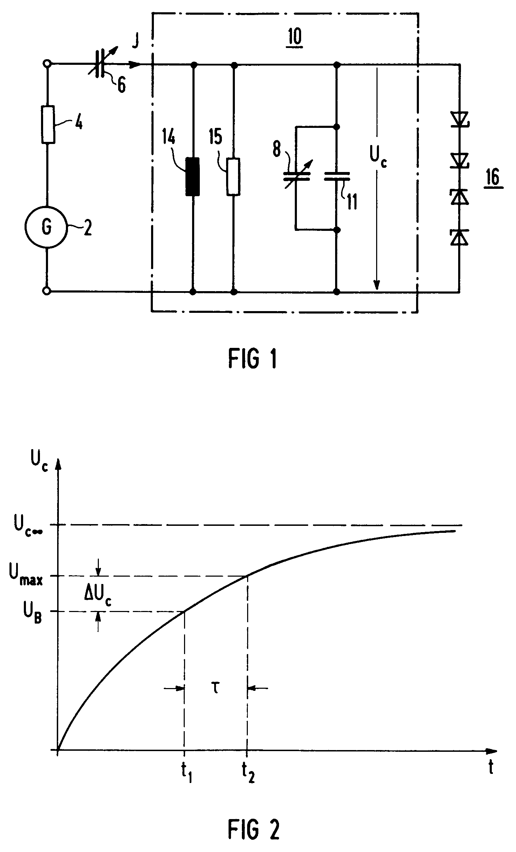

Im Ersatzschaltbild einer Antenne für eine Anordnung zum Herstellen von Schnittbildern durch magnetische Kernresonanz gemäß Figur 1 ist ein Hochfrequenzgenerator mit 2, sein Innenwiderstand mit 4, ein Serienkondensator mit veränderbarer Kapazität mit 6 und ein Resonanzkreis mit 10 bezeichnet. Der Resonanzkreis enthält einen Resonanzkondensator 11, dem ein Parallelkondensator 8 mit veränderbarer Kapazität zugeordnet ist, sowie eine Antenneninduktivität 14 und Verluste, die als Widerstand 15 dargestellt sind. Zur Begrenzung der Spannung $U_c$ am Resonanzkondensator 11 sind Begrenzungselemente 16 vorgesehen, die dem Resonanzkondensator 11 parallelgeschaltet sind. Diese Begrenzungselemente 16 können beispielsweise Zenerdioden sein, von denen zwei Reihenschaltungen gegeneinandergeschaltet sind. Für eine maximale Betriebsspannung des Resonanzkreises 10 von beispielsweise $U_B$ = 4 kV ist mit Zenerdioden oder auch sogenannte Begrenzerdioden (suppressor diodes) für eine Zenerspannung von jeweils 200 V eine Gegeneinanderschaltung von 2x25 Zenerdioden erforderlich. Zur Spannungsbegrenzung können vorzugsweise Zenerdioden mit geringer Eigenkapazität vorgesehen sein. Ihre Eigenkapazität soll vernachlässigbar klein sein gegenüber der Kapazität des Resonanzkondensators 11. Von jeder Reihenschaltung der Zenerdioden sind in der Figur zur Vereinfachung nur jeweils zwei dargestellt.

Abweichend von der dargestellten Ausführungsform gemäß Figur 1 können auch spannungsabhängige Widerstände, sogenannte Varistoren, oder auch Überspannungsableiter, vorzugsweise in der Ausführungsform als gasgefüllte Ableiter, zur Spannungsbegrenzung am Resonanzkondensator 11 vorgesehen sein.

Gemäß dem Diagramm der Figur 2, in dem die Spannung $U_c$ am Resonanzkondensator 11 über der Zeit t aufgetragen ist, nähert sich nach dem Einschalten eines Hochfrequenz-Impulses die Einhüllende der Spannung $U_c$ am Resonanzkondensator 11 einem Wert $U_{c\infty}$. Diese Einhüllende soll zur Zeit $t_1$ beispielsweise die maximal zu erwartende Betriebsspannung $U_B$ von beispielsweise $U_B$ = 4 kV erreicht haben. Beim Erreichen dieser maximalen Betriebsspannung werden die Spannungsbegrenzungselemente 16 wirksam und nach einer Schaltverzögerung $\tau$ ist zur Zeit $t_2$ der maximal zulässige Spannungswert erreicht, der beispielsweise $U_{max}$ = 5 kV betragen darf. Sind gemäß Figur 1 Reihenschaltungen von Zenerdioden zur Spannungsbegrenzung vorgesehen, deren Schaltzeiten bekanntlich sehr klein sind und in der Größenordnung von etwa 1 ns liegen, so wird die Schaltverzögerung $\tau$ mit wenigen nsec nur sehr klein sein und dementsprechend die mögliche Spannungsüberhöhung $\Delta U_c$ sehr gering sein.

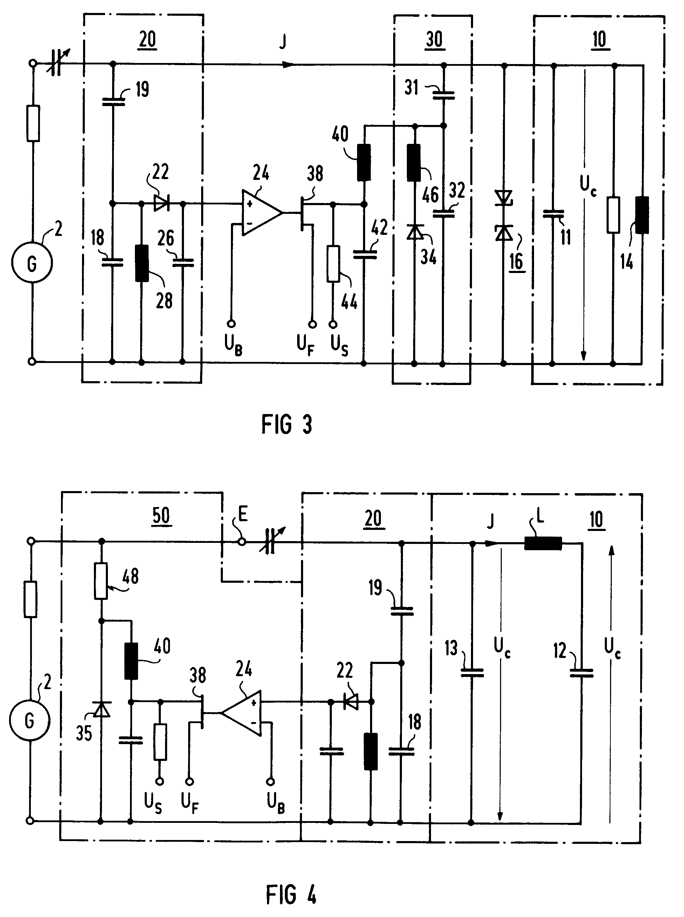

In der Ausführungsform einer Anordnung zum Betrieb der Antenne eines Kernspintomographen gemäß Figur 3 wird die Spannungsbegrenzung durch Verstimmung des Resonanzkreises 10 herbeigeführt. Zu diesem Zweck ist eine Einrichtung 20 zur Spannungsmessung am Resonanzkondensator 11 vorgesehen, die einen kapazitiven Spannungsteiler mit Meßkondensatoren 18 und 19 enthält, dessen Abgriff über eine Gleichrichterdiode 22 mit dem positiven Eingang eines Spannungskomparators 24 verbunden ist, der diesen Spannungswert mit einem Spannungsgrenzwert vergleicht, der seinem negativen Eingang zugeführt wird. Diese Einrichtung 20 zur Spannungsmessung enthält ferner einen Glättungskondensator 26 und eine Hochfrequenz-Drossel 28. Das Ausgangssignal des Spannungskomparators 24 leitet die Verstimmung des Resonanzkreises 10 ein. Zu diesem Zweck ist eine Einrichtung 30 zur Verstimmung vorgesehen, die einen Spannungteiler aus einem Verstimmungskondensator 31 und einem weiteren Verstimmungskondensator 32 enthält. Die Meßkondensatoren 18 und 19 sowie die Verstimmungskondensatoren 31 und 32 tragen zur Kompensation der Antenneninduktivität 14 bei. Sie bilden somit einen Teil der gesamten Resonanzkapazität. Der Ausgang des Komparators 24 ist über einen elektronischen Schalter 38 und eine Hochfrequenzdrossel 40 mit dem Abgriff des Spannungsteilers verbunden. Die Hochfrequenzdrossel 40 bildet mit einem Kondensator 42 einen Tiefpaß zum Abblocken der Hochfrequenz. Als elektronischer Schalter 38 kann vorzugsweise ein Feldeffekttransistor vorgesehen sein, dessen einer Elektrode über einen Vorwiderstand 44 eine positive Sperrspannung $U_S$ für eine PIN-Diode 34 zugeführt wird und dessen zweiter Elektrode eine negative Flußspannung $U_F$ für die PIN-Diode 34 zugeführt wird. Diese PIN-Diode 34 schließt, sobald sie vom Spannungskomparator 24 über den Schalter 38 durchgeschaltet wird, den Verstimmungskondensator 32 kurz, der in Reihe mit dem Verstimmungskondensator 31 dem Resonanzkondensator 11 parallelgeschaltet ist. In dieser Ausführungsform mit einer Begrenzung der Spannung $U_c$ am Resonanzkondensator 11 durch Verstimmung des Resonanzkreises 10 kann die Schaltverzögerung $\tau$ insgesamt etwa bis zu etwa 100 ns betragen.

In einer besonders vorteilhaften weiteren Ausgestaltung der in Figur 3 dargestellten Anordnung können deshalb zusätzlich noch Begrenzungselemente 16 parallel zum Resonanzkondensator 11 vorgesehen sein, welche die Spannung $U_c$ sehr schnell begrenzen. Als Begrenzungselemente können beispielsweise Reihenschaltungen von Zenerdioden vorgesehen sein, von denen zur Vereinfachung in der Figur nur lediglich jeweils eine dargestellt ist. In dieser Ausführungsform wird die Spannung $U_c$ nach wenigen ns begrenzt und die Begrenzungselemente 16 übernehmen dann den Strom I, bis die Einrichtung 30 die Spannungsbegrenzung durch Verstimmung des Resonanzkreises 10 erreicht hat.

In einer weiteren besonders vorteilhaften Ausführungsform kann der PIN-Diode 34 gemäß Figur 3 noch eine Induktivität 46 zugeordnet werden, die im Normalbetrieb der Antenne im Sperrzustand der PIN-Diode 34 praktisch unwirksam ist. Ihre Induktivität kann vorzugsweise so bemessen sein, daß sie im Falle einer Spannungsüberhöhung im Resonanzkreis 10 nach dem Durchschalten der PIN-Diode 34 mit dem Verstimmungskondensator 32 einen Resonanzkreis bildet, der eine entsprechend größere Verstimmung bewirkt.

In der Ausführungsform einer Spannungsbegrenzung im Resonanzkreis 10 mit einer Aufteilung der Resonanzkapazität durch Resonanzkondensatoren 12 und 13 gemäß Figur 4 wird die Spannungsbegrenzung durch eine Einrichtung 50 zur Leistungsbegrenzung herbeigeführt. Dem Resonanzkreis 10 ist ebenfalls die Einrichtung 20 zur Spannungsmessung zugeordnet, die eine Reihenschaltung des Meßkondensators 18 mit dem weiteren Meßkondensator 19 enthält. Mit einer Kapazität des Resonanzkondensators 12 von beispielsweise 100 pF werden die Größe des Resonanzkondensators 13 sowie der Meßkondensatoren 18 und 19 so gewählt, daß sie zusammen etwa 100 pF ergeben. In dieser Ausführungsform kann dann beispielsweise ein Meßkondensator 18 mit 40 pF und ein Meßkondensator 19 mit 10 pF vorgesehen sein. Die Spannung am Spannungsteiler der Meßeinrichtung 20 wird wie in der Ausführungsform gemäß Figur 3 über die Diode 22 dem Spannungskomparator 24 zugeführt, dessen Ausgangssignal über den Schalter 38 und die Hochfrequenzdrossel 40 der Einrichtung 50 zur Leistungsbegrenzung zugeführt wird und eine PIN-Diode 35 durchschaltet, die in dieser Ausführungsform in Reihe mit einer Parallelimpedanz 48 dem Eingang E der Antenne parallelgeschaltet ist. Durch die Einschaltung der Parallelimpedanz 48 wird ein Teil der Hochfrequenzleistung am Eingang E der Antenne reflektiert. Mit dieser sprunghaften Erhöhung des Reflexionsfaktors $\tau$ wird die Leistungszufuhr vom Hochfrequenzgenerator 2 soweit begrenzt, daß ein weiterer Anstieg der Spannung $U_c$ im Resonanzkreis 10 nicht mehr möglich ist. Die Parallelimpedanz 48, die am Eingang der Antenne durch die PIN-Diode 35 eingeschaltet wird, kann aus einem ohmschen Widerstand bestehen, dessen Größe beispielsweise etwa 20 Ohm betragen kann. Ferner ist auch ein kapazitiver Widerstand oder auch ein induktiver Widerstand geeignet.

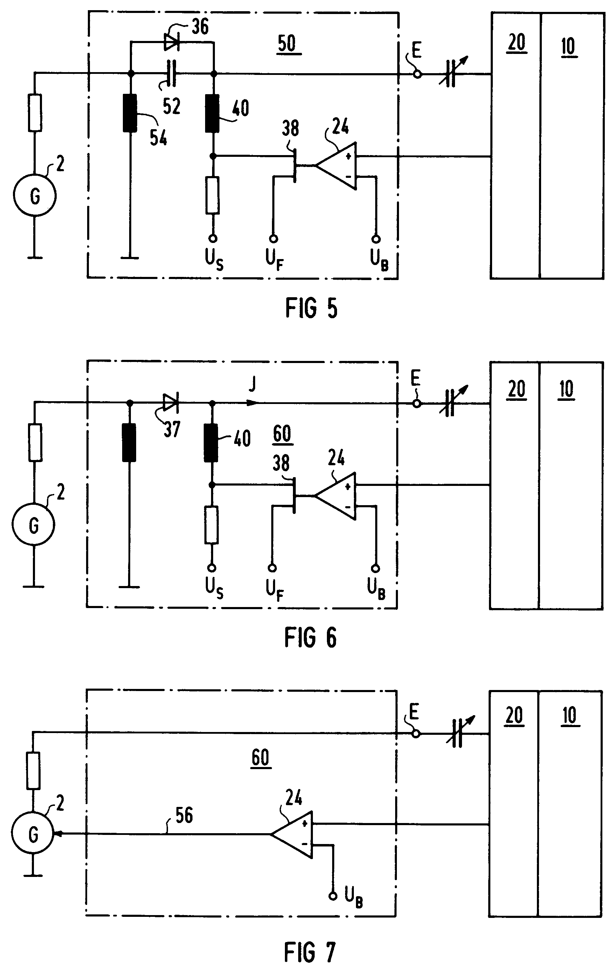

Eine Spannungsbegrenzung im Resonanzkreis 10 erhält man gemäß Figur 5 durch eine Einrichtung 50 zur Begrenzung der Leistungszufuhr zur Antenne. Zu diesem Zweck ist dem Eingang E ein Begrenzungskondensator 52 vorgeschaltet, dem eine PIN-Diode 36 parallelgeschaltet ist. Diese wird in Abhängigkeit von der Spannung $U_c$ im Resonanzkreis 10 durch den Spannungskomparator 24 über den Schalter 38 und die HF-Drossel 40 durchgeschaltet, sobald die Spannung $U_c$ den eingestellten Grenzwert $U_B$ erreicht. Durch die PIN-Diode 36 wird der Kondensator 52, der einen Teil des Anpaßkondensators 6 bildet, kurzgeschlossen und somit durch Erhöhung des Reflexionsfaktors die Leistungszufuhr begrenzt. Zum Schutz des Generators 2 vor den Gleichspannungen $U_S$ und $U_F$ kann noch eine HF-Drossel 54 vorgesehen sein.

In einer Ausführungsform gemäß Figur 6 ist zur Spannungsbegrenzung eine Einrichtung 60 zur Unterbrechung der Leistungszufuhr vorgesehen, die eine dem Eingang E der Antenne vorgeschaltete PIN-Diode 37 enthält. Im ungestörten Betrieb ist diese PIN-Diode 37 durchgeschaltet und führt den Strom I. Dem Schalter 38 wird in dieser Ausführungsform eine negative Flußspannung $U_F$ zugeführt. Sobald die Spannung $U_c$ im Resonanzkreis 10 den Grenzwert $U_B$ erreicht, wird die PIN-Diode 37 vom Spannungskomparator 24 durch ein entsprechendes Ausgangssignal über den Schalter 38 und die HF-Drossel 40 gesperrt und damit die Leistungszufuhr unterbrochen.

Das Ausgangssignal des Spannungskomparators 24 kann jedoch gemäß Figur 7 auch direkt zum Generator 2 übertragen werden, beispielsweise über eine Steuerleitung 56 aus einem Glasfaserkabel, und den Generator 2 unwirksam machen. Zu diesem Zweck kann das Ausgangssignal beispielsweise den Endverstärker des Generators 2 blockieren.

**Patentansprüche**

1. Anordnung zum Herstellen von Schnittbildern eines Untersuchungsobjekts durch magnetische Kernresonanz mit einem magnetischen Grundfeld sowie Gradientenfeldern und einer Hochfrequenzantenne für Sende- und Empfangsbetrieb, deren Induktivität mit wenigstens einem Resonanzkondensator einen Resonanzkreis bildet, **gekennzeichnet** durch eine Begrenzung der Spannung $U_c$ am Resonanzkondensator (11, 12, 13) im Sendebetrieb.

2.  Anordnung nach Anspruch 1, **dadurch gekennzeichnet,** daß als Begrenzungselemente (16) am Resonanzkondensator (11) gegengeschaltete Zenerdioden vorgesehen sind (Figur 1).

3.  Anordnung nach Anspruch 1, **dadurch gekennzeichnet,** daß als Begrenzungselemente (16) am Resonanzkondensator (11) Varistoren vorgesehen sind.

4.  Anordnung nach Anspruch 1**, dadurch gekennzeichnet,** daß als Begrenzungselemente (16) am Resonanzkondensator (11) Überspannungsableiter vorgesehen sind.

5.  Anordnung nach Anspruch 1, **dadurch gekennzeichnet,** daß zur Spannungsbegrenzung eine Einrichtung (30) zur Verstimmung des Resonanzkreises (10) vorgesehen ist (Figur 3).

6.  Anordnung nach Anspruch 5, **dadurch gekennzeichnet,** daß die Einrichtung (30) eine PIN-Diode (34) enthält, die in Abhängigkeit von der Spannung $U_c$ am Resonanzkondensator (11) durchgeschaltet wird und den Resonanzkreis (10) verstimmt (Figur 3).

7.  Anordnung nach Anspruch 6, **dadurch gekennzeichnet,** daß eine Einrichtung (20) zur Spannungsmessung vorgesehen ist, die einen Spannungsteiler enthält, der dem Resonanzkondenstor (11) parallelgeschaltet ist und dessen Abgriff mit dem positiven Eingang eines Spannungskomparators (24) verbunden ist, dessen negativem Eingang ein Spannungsgrenzwert ($U_B$) vorgegeben ist und der beim Überschreiten dieses eingestellten Spannungsgrenzwertes ($U_B$) die PIN-Diode (34) durchschaltet, die einen Verstimmungskondensator (32) kurzschließt.

8.  Anordnung nach Anspruch 7, **dadurch gekennzeichnet,** daß die PIN-Diode (34) mit einer Hochfrequenzdrossel (46) in Reihe geschaltet ist, die mit der Kapazität des Verstimmungskondensators (32) einen Resonanzkreis bildet.

9.  Anordnung nach einem der Ansprüche 6 bis 8, **dadurch gekennzeichnet,** daß dem Resonanzkondensator (11) Spannungsbegrenzungselemente (16) parallelgeschaltet sind.

10.  Anordnung nach Anspruch 1, **dadurch gekennzeichnet,** daß zur Spannungsbegrenzung eine Einrichtung (50) zur Begrenzung der Leistungszufuhr zum Resonanzkreis (10) vorgesehen ist (Figur 4).

11.  Anordnung nach Anspruch 10, **dadurch gekennzeichnet,** daß die Einrichtung (50) zur Begrenzung der Leistungszufuhr eine dem Eingang E der Hochfrequenzantenne prallelgeschaltete Reihenschaltung einer Parallelimpedanz (48) mit einer PIN-Diode (35) enthält, die im Ausgangskreis eines Spannungskomparators (24) angeordnet ist, dem von einer Meßeinrichtung (20) für die Spannung $U_c$ am Resonanzkondensator (13) eine dieser Spannung $U_c$ proportionale Spannung und ein Spannungsgrenzwert $U_B$ vorgegeben ist und dessen Ausgangssignal die PIN-Diode (35) durchschaltet, sobald die von der Meßeinrichtung (20) vorgegebene Spannung den Spannungsgrenzwert $U_B$ erreicht (Figur 4).

12.  Anordnung nach Anspruch 10, **dadurch gekennzeichnet,** daß die Einrichtung (50) zur Begrenzung der Leistungszufuhr einen Begrenzungskondensator (52) enthält, der am Eingang E der Antenne mit einem Serienkondensator (6) in Reihe geschaltet ist und dem eine PIN-Diode 36 parallelgeschaltet ist, die in Abhängigkeit von der Spannung $U_c$ im Resonanzkreis durchgeschaltet wird (Figur 5).

13.  Anordnung nach Anspruch 1, **dadurch gekennzeichnet,** daß zur Spannungsbegrenzung eine Einrichtung (60) zur Unterbrechung der Leistungszufuhr zum Resonanzkreis (10) vorgesehen ist.

14.  Anordnung nach Anspruch 13, **dadurch gekennzeichnet,** daD die Einrichtung (60) zur Unterbrechung der Leistungszufuhr eine dem Eingang E der Hochfrequenzantenne vorgeschaltete PIN-Diode (37) enthält, die im Ausgangskreis eines Spannungskomparators (24) angeordnet ist, der in Abhängigkeit von einem Spannungsgrenzwert $U_B$ die PIN-Diode (37) sperrt (Figur 6).

15.  Anordnung nach Anspruch 13, **dadurch gekennzeichnet,** daß dem Resonanzkondensator (13) eine Meßeinrichtung (20) zur Spannungsmessung zugeordnet ist, deren Ausgangsspannung einem Eingang eines Spannungskomparators (24) vorgegeben ist, dessen zweitem Eingang ein Spannungsgrenzwert $U_B$ vorgegeben ist und der über eine Steuerleitung (56) den Hochfrequenzgenerator (2) abschaltet, sobald die von der Meßeinrichtung (20) gelieferte Spannung den Spannungsgrenzwert $U_B$ erreicht (Figur 7).

FIG 1

FIG 2

FIG 3

FIG 4

FIG 5

FIG 6

FIG 7

Europäisches Patentamt

**EUROPÄISCHER RECHERCHENBERICHT**

Nummer der Anmeldung

EP 91 11 9851

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | REVIEW OF SCIENTIFIC INSTRUMENTS Band 61, Nr. 1, Teil 1, Januar 1990, Seiten 69-76, New York, US; A. RETOURNARD et al.: "A versatile secondary transmitter unit for nuclear magnetic resonance" * Seite 71, Spalte 1, Zeilen 8-23; Seite 73, Spalte 2, Zeile 27 - Seite 74, Spalte 1, Zeile 5; Abbildungen 1,5 * | 1,4,10, 13,15 | G 01 R 33/36 |
| Y | idem | 2,5,6, 11,14 | |
| Y | EP-A-0 262 495 (SIEMENS AG) * Spalte 1, Zeilen 43-50; Spalte 2, Zeilen 14-47; Spalte 6, Zeilen 9-50; Abbildung 5 * | 2,5,6, 11,14 | |
| A | | 1,3,4,7 -9,12 | |
| A | EP-A-0 276 508 (N.V. PHILIPS' GLOEILAMPENFABRIEKEN) * ganzes Dokument * | 1-15 | **RECHERCHIERTE SACHGEBIETE (Int. Cl.5)** G 01 R |
| A | EP-A-0 315 382 (THE REGENTS OF THE UNIVERSITY OF CALIFORNIA) * Zusammenfassung; Ansprüche 1-5; Abbildungen 1-2B * | 1-15 | |
| A | DE-A-3 728 863 (SIEMENS AG) * ganzes Dokument * | 1-15 | |
| P,A | DE-U-9 012 639 (SIEMENS AG) * ganzes Dokument * | 1-15 | |

Der vorliegende Recherchenbericht wurde für alle Patentansprüche erstellt

| Recherchenort | Abschlußdatum der Recherche | Prüfer |
|---|---|---|
| BERLIN | 25-02-1992 | MOUTARD P.J. |